**Europäisches Patentamt**

**European Patent Office**

**Office européen des brevets**

(11) Veröffentlichungsnummer: **0 647 867 A1**

## (12) EUROPÄISCHE PATENTANMELDUNG

(21) Anmeldenummer: **94115860.2**

(22) Anmeldetag: **07.10.94**

(51) Int. Cl.6: **G02F 1/00**, H01S 3/085

(30) Priorität: **09.10.93 DE 4334525**

(43) Veröffentlichungstag der Anmeldung:
**12.04.95 Patentblatt 95/15**

(84) Benannte Vertragsstaaten:
**DE ES FR GB IT NL**

(71) Anmelder: **ANT Nachrichtentechnik GmbH**
**Gerberstrasse 33**
**D-71522 Backnang (DE)**

(72) Erfinder: **Hansmann, Stefan**
**Bingerstrasse 16**
**D 64295 Darmstadt (DE)**
Erfinder: **Hillmer, Hartmut**
**Peter-Behrens-Strasse 12**
**D-64287 Darmstadt (DE)**

(54) **Optoelektronisches Bauelement mit verteilter Rückkopplung und variierbarem Kopplungskoeffizienten.**

(57) 1.2.Bei bisher verwendeten optoelektronischen Bauelementen ist eine optimale Anpassung des Kopplungskoeffizient an den konkreten Einzelfall nicht zu erreichen. Das optoelektronische Bauelement soll in seiner Struktur so verändert werden, daß eine Anpassung des Kopplungskoeffizienten an den konkreten Einzelfall ermöglicht wird.

2.2.Erfindungsgemäß ist das axiale Gesamtgitter (G) des optoelektronischen Bauelements aus einer Vielzahl von einzelnen Sektionen (P) aufgebaut, wobei jede Sektion (P) wiederum aus mindestens einem Untergitter-Feld (UG) und mindestens einem gitterfreien Zwischenbereich (GZ) besteht. Die Untergitter-Felder (UG) weisen dabei unterschiedliche individuelle Längen ($L_{ug,i}$)auf, und die gitterfreien Zwischenbereiche (GZ) weisen unterschiedliche individuelle Längen ($L_{p,i} - L_{ug,i}$) auf.

2.3.Durch den erfindungsgemäßen Gitteraufbau des optoelektronischen Bauelements läßt sich der Gitter-Kopplungskoeffozient ($\Lambda$) in kleinen Schritten über einem Teil der axialen Bauelementelänge (L) nahezu beliebig variieren.

Fig. 1

Die erfindungsgemäße Lösung ist in auf DFB- oder DBR-Gittern basierenden optoelektronischen Bauelementen, wie z. B. Lasern, Laser-Verstärkern, Filtern, Kopplern und Schaltern anwendbar.

Bekannt ist eine abrupte Änderung des Kopplungskoeffizienten (K) in longitudinaler Richtung des optoelektronischen Bauelements durch partielle Photolack-Remaskierung nach einer Teiltrockenätzung des DFB-Gitters, wie z. B. bei M. Matsuda et al., Conference on InP and related compounds (1991) beschrieben.

Wie bei A. Talneau et al., Electron. Lett. 28, 1395 (1992) ausgeführt, ist eine axiale Variation des Kopplungskoeffizienten K durch die Doppelbelichtung einer auf einer Wafer-Oberfläche aufgetragenen Photolackschicht realisierbar. Der Photolack enthält nach der Doppel-Belichtung die Information zweier sich überlagernder und durchdringender homogener DFB-Gitter, welche sich in ihrer Gitterperiode allerdings um $\triangle\Lambda$ unterscheiden. Dieses Verfahren ermöglicht abhängig von der Wahl von $\triangle\Lambda$ jeweils nur eine vollständig definierte Funktion $K(z)$, sowie genau eine dazu korrespondierende Bauelementelänge L, wenn die Periodizität der Struktur in Hinblick auf hohe Bauelementeausbeute genutzt wird. Die Vorteile, welche eine beliebige Änderung $K(z)$ bietet, können mit diesem Verfahren nicht genutzt werden.

Die technische Aufgabe der Erfindung besteht darin, die Gitterstruktur eines optoelektronischen Bauelements so auszunutzen und reproduzierbar zu verändern, daß das optoelektronische Bauelement bezüglich seines Kopplungskoeffizienten K an den konkreten Einsatzfall optimal angepaßt ist.

Die erfindungsgemäße Lösung basiert auf einem optoelektronischen Bauelement mit DFB- oder DBR-Gitter, welches auf dem Halbleiter-Substrat eine oder mehrere Halbleiter-Schichten enthält. Die Halbleiter-Schicht/en ist/sind derart strukturiert, daß eine optische Rückkopplung entsteht, wobei eine periodische Variation des Realteils oder des Imaginärteils des Brechungsindexes oder des Real- und Imaginärteils des Brechungsindexes gleichzeitig in axialer Bauelementerichtung z zu verzeichnen ist. Erfindungsgemäß setzt sich das axiale Gesamtgitter G des optoelektronischen Bauelements aus einer Vielzahl einander nachgeordneter einzelner Sektionen P zusammen. Jede Sektion P besteht wiederum aus mindestens einem Untergitter-Feld UG und einem gitterfreien Zwischenbereich GZ. Die Längen der einzelnen Untergitter-Felder $L_{ug,i}$ sind individuell unterschiedlich ausgebildet. Die individuellen Längen $L_{p,i}$ - $L_{ug,i}$ der einzelnen gitterfreien Zwischenbereiche GZ weisen ebenfalls unterschiedliche Beträge aus. Dadurch wird es ermöglicht, daß der Gitter-Kopplungskoeffizient K in axialer Richtung z nicht konstant, sondern über einem Teil der axialen Bauelementelänge L variiert.

Die erfindungsgemäße Lösung wird anhand eines Ausführungsbeispiels näher erläutert.

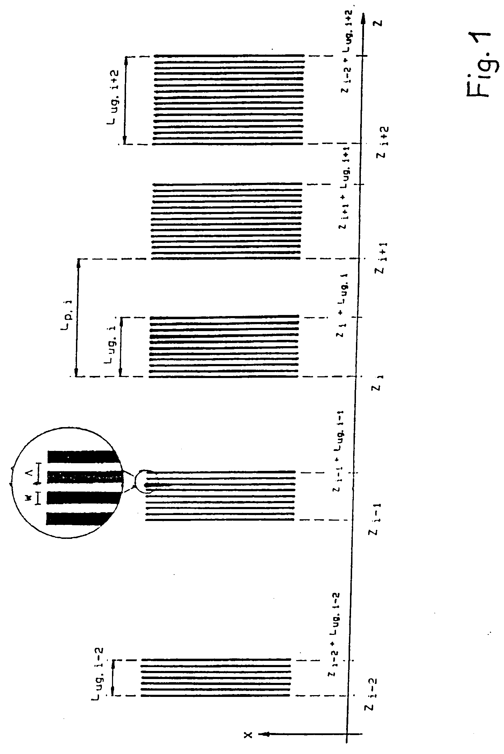

Fig.1 zeigt anhand einer schematischen Abbildung eine Schnittebene (xz-Ebene) durch die Beugungsgitterebene.

Der maximale Wert des Kopplungskoeffizienten K tritt in jenen Sektionen P auf, in denen das Verhältnis der Länge der Untergitter-Felder $L_{ug,i}$ zu der Länge der Sektion $L_{p,i}$ maximal ist. Das heißt, daß der Kopplungskoeffizient K am größten ist, wenn in der betreffenden Sektion P kein gitterfreier Zwischenbereich GZ mehr existiert, d. h., wenn $L_{ug,i}$ = $L_{p,i}$ gilt. Diese Abmessungen sind in axialer = longitudinaler Richtung z des optoelektronischen Bauelements definiert, in der auch der optische Wellenleiter des Bauelements verläuft. Im Folgenden wird mit $K_o$ derjenige Kopplungskoeffizient bezeichnet, der in einem in axialer Richtung z vollständig homogenen axialen Gesamtgitter G mit axial konstanter Gitterperiode $\Lambda$, mit axial konstantem Tastverhältnis $W/\Lambda$ und mit der konstanten Gittergraben-Tiefe a (vertikale Ausdehnung des Gitters), vorliegt.

Der Kopplungskoeffizient $K_o$ wird durch die laterale und vor allem die vertikale Geometrie der Bauelementestruktur und der Brechungsindizes der einzelnen Halbleiter-Schichten, sowie durch die Gittergraben-Tiefe a und das Tastverhältnis $W/\Lambda$ bestimmt. Die Stegbreite W des Gesamtgitters G variiert im Bereich $0<W<\Lambda$. Die Berechnung des Kopplungskoeffizienten $K_o$ erfolgt nach bekannten Verfahren wie z. B. veröffentlicht durch H.Kogelnik and C. V. Shank, J. Appl. Phys. 43, 2327 (1972).

Der lokale, über eine Sektion P gemittelte Kopplungskoeffizient $K_i$, kann in Abhängigkeit von der lokalen Wahl der Länge des Untergitter-Feldes $L_{ug,i}$ und der Länge der Sektion $L_{p,i}$ im Bereich $K_o \geq K \geq 0$ variabel festgelegt werden. In Sektionen P ganz ohne Untergitter-Feld UG, liegt der Grenzfall $K_i$ = 0 vor. Der entgegengesetzte Grenzfall $K_i$ = $K_o$ findet sich in denjenigen Sektionen P, in welchen keine gitterfreien Zwischenbereiche GZ liegen. Der lokale Kopplungskoeffizient $K_i$ in einer Sektion P läßt sich näherungsweise nach der Gleichung $K_i$ = $K_o$ • $L_{ug,i}/L_{p,i}$ errechnen. Durch entsprechende Wahl der mathematischen Folge $L_{ug,1},L_{ug,2},...L_{ug,i}...L_{ug,n}$, sowie der dazu korrespondierenden Folge $L_{p,1},L_{p,2},...L_{p,i}...L_{p,n}$, kann der Kopplungskoeffizient von Sektion P (i = 1) zu Sektion p (i = n) in sehr kleinen Schritten nahezu beliebig variiert werden. Es gilt dabei grundsätzlich $0 \leq L_{ug,i} \leq L_{p,i}$, wobei i ganzzahlig im Bereich $0 \leq i \leq n$ läuft.

Die erfindungsgemäße Lösung soll an einigen konkreten Beispielen näher erläutert werden.

Im ersten Beispiel ist die axiale Position des linken Randes der Untergitter-Felder UG in z-Richtung periodisch. Es gilt $z_i$ = $z_1$ + (i-1) • $L_p$. Dadurch

haben alle Sektionen P die gleiche Länge $L_p$. Die Untergitter-Felder UG weisen jedoch unterschiedliche Längen $L_{ug,i}$ auf.

Ein Zahlenbeispiel zu dieser Ausführungsform: Bauelementelänge $L = 658\mu m$ , $L_p = 9,4\mu m$, das Bauelement enthält im Gesamtgitter G gerade 70 Untergitter-Felder UG und 70 gitterfreie Zwischenbereiche GZ, $\Lambda = 235\mu m$, $W/\Lambda = 0,45$ und $L_{ug,1} = 1,175\mu m$. $L_{ug,i}$ steigt mit wachsendem i innerhalb bestimmter Grenzen, jedoch beliebig, in 32 Stufen vom linken Minimalwert $L_{ug,1} = 1,175\mu m$ auf den Maximalwert $L_{ug,33} = 9,165\mu m$ an und fällt von dort mit wachsendem i in 37 Schritten auf $L_{ug,70} = 0`94\mu m$ ab. In diesem Fall variiert der Kopplungskoeffizient K über die axiale Bauelementelänge L ungefähr zwischen $K_o$ und $0,1 \cdot K_o$.

In einem zweiten Beispiel weisen die Untergitter-Felder UG immer die gleiche Länge $L_{ug}$ auf. In dieser Ausführungsform variieren im Gegensatz zum ersten Beispiel die individuellen Längen $L_{p,i}$ - $L_{ug}$ der gitterfreien Zwischenbereiche GZ von Sektion zu Sektion.

Eine weitere Ausführungsform beruht auf der variablen Ausführung sowohl der Länge der Untergitter-Felder $L_{ug,i}$, als auch der Sektionslängen $L_{p,i}$ und gleichzeitig damit der individuellen Längen $L_{p,i}$ - $L_{ug,i}$ der gitterfreien Zwischenbereiche GZ von Sektion zu Sektion

Im Folgenden soll die Variation des lokalen Kopplungskoeffizienten K(z) durch eine lokale Variation des Verhältnisses $L_{p,i}/L_{ug,i}$ demonstriert werden.

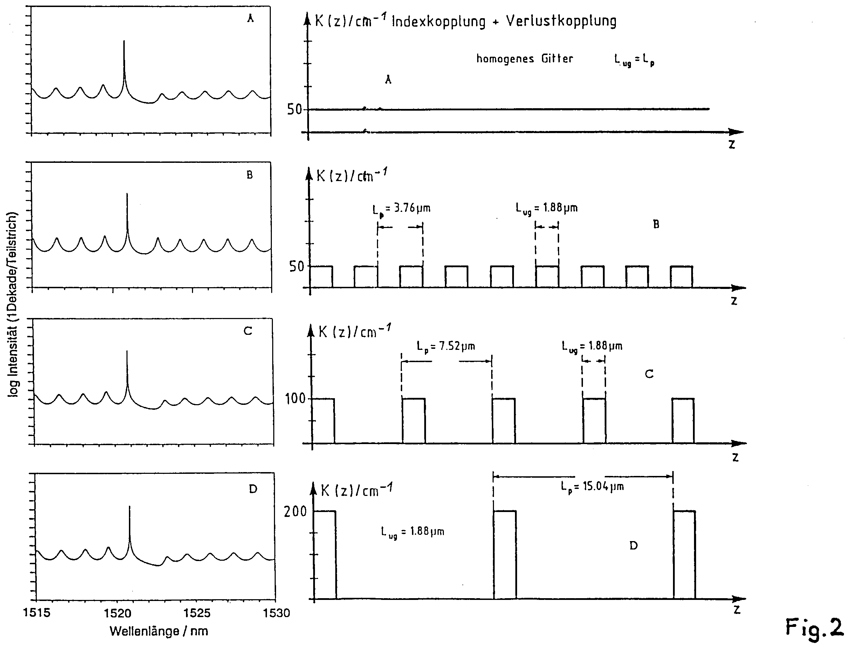

Berechnet werden Emissionsspektren unter Verwendung der Transfermatrix-Methode (siehe z. B. S. Hansmann, IEEE J. Quant. Electron $\underline{28}$, 2589 (92)]. Der Betrag der Kopplungskoeffizienten kann in erster Näherung durch die Breite des Stopbandes im DFB-Spektrum (siehe Fig.2 u. 3) verdeutlicht werden.

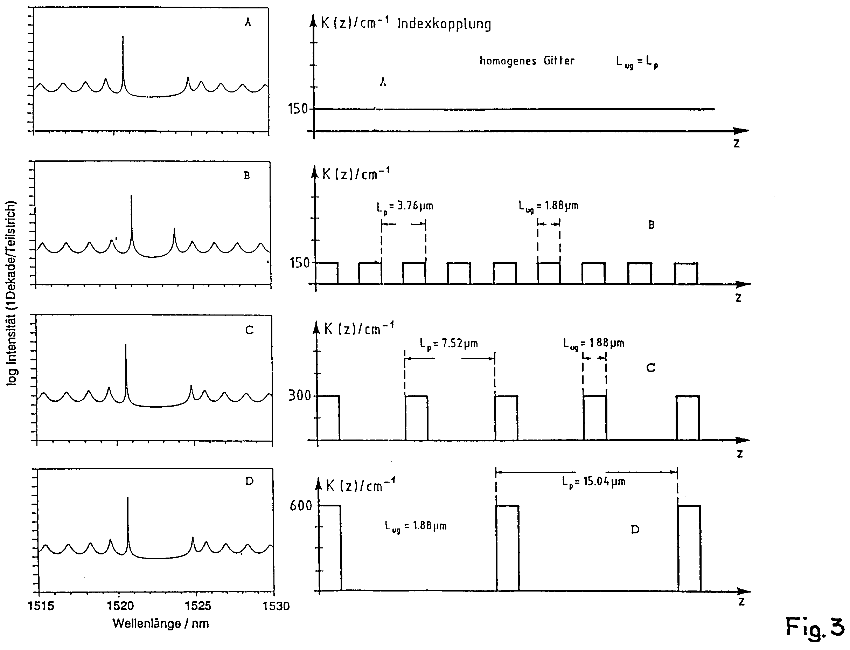

In Fig. 2 und 3 sind links je vier Spektren gezeigt, welche zu den korrespondierenden (im Bild rechts abgebildeten) Kopplungskoeffizienten-Verläufen K(z) gehören.

In Fig. 2 wird der Fall der Kopplung über die Variation des Real- und Imaginärteils des vertikalen Brechungsindexes in longitudinaler Richtung gezeigt.

In Fig. 3 wird der Fall der Kopplung über die Variation nur des Realteils des Brechungsindex gezeigt. Die Größe des Kopplungskoeffizienten innerhalb eines Gitterbereichs im Fall C und D wird z.B. durch unterschiedliche Gittergrabentiefe a eingestellt.

Der Unterschied zwischen Spektrum A und B (siehe Fig.2 bzw. Fig.3) verdeutlicht jeweils die Wirksamkeit der Methode, den Kopplungskoeffizienten über den Einbau gitterfreier Teilbereiche in das Gesamtgitter zu variieren. Die fast vollständige Übereinstimmung der Spektren A, C und D verdeutlicht, daß die Wirkung der verschieden ausgeführten DFB-Gitter in den gezeigten Fällen beinahe identisch ist. Dies demonstriert, daß die Variation von $L_p$ und $L_{ug}$ innerhalb gewisser Grenzen die Variation von K erlaubt, ohne die Wirkung und die spektralen Eigenschaften des DFB-Gitters stark zu modifizieren. Im Falle, daß $L_p$ = konstant und $L_{ug}$ = konstant sind, wie jeweils in den einzelnen Fällen (A - D) in den Fig. 2 und 3, treten durch die vollständige Periodizität der Gitter (bezüglich $L_{ug}$ und $L_p$) jedoch für bestimmte Werte von $L_{ug}$ und $L_P$ sogenannte Supermoden auf, deren Wellenlängenabstand $\Delta\lambda$ z. B. nach folgender Formel berechnet werden kann

$$\Delta\lambda = \frac{\lambda^2}{2\, n_{eff} \cdot L_P}$$

Dabei ist $\lambda$ die Zentralwellenlänge des Bauelements (z. B. die Bragg-Mode des DFB Gitters) und $n_{eff}$ der effektive Brechungsindex der Halbleiterschichtstruktur des Bauelements. Falls diese Supermoden im DFB-Spektrum bei der Anwendung des Bauelements stören sollten, wählt man $L_{ug,i}$ und $L_{p,i}$ derart, daß der Wellenlängenabstand $\Delta\lambda$ der Supermoden größer als der im Bauelement zu nutzende spektrale Bereich (z. B. Breite des Optischen Verstärkungsprofils) ist.

Zahlenbeispiel: Mit $\Delta\lambda > 50$ nm, $\lambda = 1.55\ \mu m$, $n_{eff} = 3.25$ ergibt sich $L_p < 7.5\ \mu m$.

Als untere Grenze ist $L_p > 3\Lambda$ anzusetzen.

Im Fall D ist jedoch zu erkennen, daß der wesentliche Teil des Spektrums, d. h. in der Nähe der Bragg-Mode $\lambda$, selbst bei $L_p = 15.04\ \mu m$ noch nicht modifiziert ist.

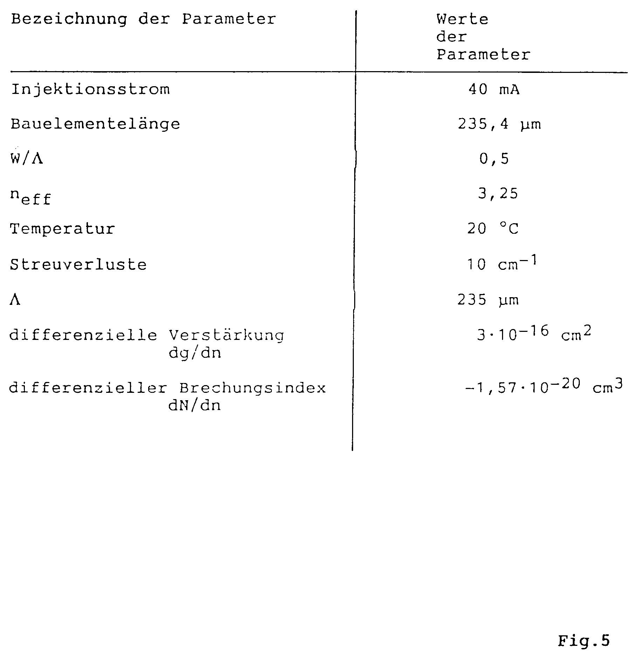

Die Parameter zu den o.a. Rechnungen sind tabellarisch in Fig. 5 aufgeführt.

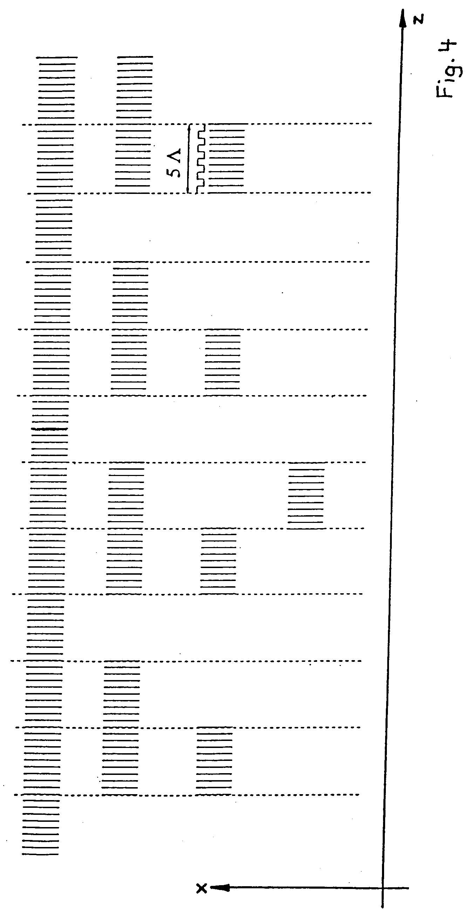

Figur 4 zeigt das Beispiel eines Gitterverlaufs, welcher zu einer Variation des Kopplungskoeffizienten zwischen den in lateraler Richtung benachbarten Wellenleitern genutzt werden kann. In axialer Richtung ist in diesem Beispiel das Gitter eines jeden axialen Wellenleiters streng periodisch und homogen, so daß der Kopplungskoeffizient in axialer Richtung konstant ist. Auf diese Weise können auf einem Halbleiter-Wafer Bauelemente mit unterschiedlichen Kopplungskoeffizienten realisiert werden unter Beibehaltung z. B. der restlichen geometrischen Parameter und der Prozeßparameter bei der technologischen Realisierung.

Die in der axialen Variation des Kopplungskoeffizienten K enthaltenen Parameter, insbesondere die mathematische Folge $L_{ug,1}$, $L_{ug,2}$,...$L_{ug,i}$...$L_{ug,n}$, sowie die korrespondierende mathematische Folge

$L_{p,1}$, $L_{p,2}$,...$L_{p,i}$...$L_{p,n}$, sowie ferner $\Lambda$, $W/\Lambda$, a, die einzelnen Schichtdicken, deren laterale Ausdehnungen und deren Brechungsindizes, können so optimiert werden, daß das optoelektronische Bauelement mit entsprechend der vorgesehenen Bauelemente-Anwendung angepaßten Kenngrößen versehen ist. Für einen Halbleiterlaser können mittels der erfindungsgemäßen Lösung beispielsweise folgende Parameter optimiert oder verbessert werden:

- kleinere Linienbreiten der optischen Emission
- reduziertes spektrales Lochbrennen und damit Verbesserung der longitudinalen Einmoden-Stabilität, sowie das Ermöglichen höherer optischer Leistungen
- Linearisierung der Strom-Leistungskennlinie und Verbesserung der Lichtausbeute
- bessere Hochfrequenzeigenschaften, wie reduzierter Frequenz-Chirp und höhere Grenzfrequenz unter hochfrequenter Modulation
- stabilere longitudinale Einwelligkeit bei hoher Ausgangsleistung
- mögliche Schwellstrom-Erniedrigung der Hauptmode und mögliche Schwellstrom-Erhöhung der Seitenmoden

Mittels der erfindungsgemäßen Lösung ist eine äußerst präzise Variation des Kopplungskoeffizienten K in axialer Richtung möglich.

Für den Fall, daß zur Gitterdefinition Elektronen-Strahl-Lithographie verwendet wird, ergibt sich durch Einsparen von teurer Schreibzeit ein weiterer Vorteil, wenn man die in axialer Richtung homogenen Gittern mit den hier vorgeschlagenen, unterbrochenen Gittern vergleicht.

**Patentansprüche**

1. Optoelektronisches Bauelement mit verteilter Rückkopplung und variierbarem Kopplungskoeffizienten, mit mindestens einer Halbleiter-Schicht, die derart strukturiert ist, daß eine optische Rückkopplung der geführten Lichtwelle entsteht, wobei eine periodische Variation des Realteils oder des Real- und Imaginärteils des Brechungsindex gleichzeitig in axialer Bauelementerichtung existiert, **dadurch gekennzeichnet**, daß das axiale Gesamtgitter (G) aus einer Vielzahl von einzelnen einander nachgeordneten Sektionen (P) besteht, daß jede Sektion (P) aus mindestens einem Untergitter-Feld (UG) und mindestens einem gitterfreien Zwischenbereich (GZ) besteht, daß die Untergitter-Felder (UG) unterschiedliche individuelle Längen ($L_{ug,i}$) und die gitterfreien Zwischenbereiche (GZ) unterschiedliche individuelle Längen ($L_{p,i}$ - $L_{ug,i}$) aufweisen, so daß der Gitter-Kopplungskoeffizient (K) in axialer Richtung (z) nicht konstant, sondern in kleinen Schritten über einem Teil der axialen Bauelementelänge (L) nahezu beliebig variierbar ist.

2. Optoelektronisches Bauelement nach Anspruch 1, dadurch gekennzeichnet, daß in axialer Richtung (z) die Länge ($L_{p,i}$ - $L_{ug,i}$) mindestens eines gitterfreien Zwischenbereichs (GZ) an mindestens einer axialen Position des Bauelements gleich Null ist.

3. Optoelektronisches Bauelement nach Anspruch 1, dadurch gekennzeichnet, daß in axialer Richtung (z) die Länge mindestens eines Untergitter-Feldes ($L_{ug,i}$) an mindestens einer axialen Position des Bauelements gleich Null ist.

4. Optoelektronisches Bauelement nach Anspruch 1, 2 und 3, dadurch gekennzeichnet, daß durch axiale Veränderung des Tastverhälnisses ($W/\Lambda$) der Untergitter-Felder (UG) in longitudinaler Richtung (z) eine örtliche Feinabstimmung des Kopplungskoeffizienten (K) bewirkt wird.

5. Optoelektronisches Bauelement nach Anspruch 1, 2 und 3, dadurch gekennzeichnet, daß das Minimum bzw. das Maximum des Kopplungskoeffizienten (K) an jeder beliebigen axialen Position jeder Sektion (P) angeordnet sein kann.

6. Optoelektronisches Bauelement nach Anspruch 1, 2 und 3, dadurch gekennzeichnet, daß die Phase zweier beliebiger Gitterfelder gegeneinander in einem Bereich zwischen 0 und $2\pi$ verschiebbar ist, so daß Phasenverschiebungen im axialen Gesamtgitter (G) erzeugt oder ausgeglichen werden können.

7. Optoelektronisches Bauelement nach Anspruch 1, 2 und 3, dadurch gekennzeichnet, daß die in lateraler Richtung (x) auf dem Halbleiterwafer nebeneinanderliegenden Sektionen (P), welche zu lateral benachbarten Wellenleitern gehören, in axialer Richtung (z) unterschiedliche Sektionslängen ($L_{p,j}$) und/oder unterschiedliche Längen der Untergitter-Felder ($L_{ug,j}$) und/oder ein unterschiedliches Verhältnis ($L_{p,j}/L_{ug,j}$) aufweisen, so daß der Gitter- Kopplungskoeffizient (K) nicht nur in axialer Richtung (z) variiert, sondern auch zwischen lateral benachbarten Bauelementen auf dem Halbleiterwafer.

8. Optoelektronisches Bauelement nach Anspruch 1, dadurch gekennzeichnet, daß alle Untergitter-Felder (UG) die gleiche Gitterperiode $\Lambda$, die gleiche Gittertiefe a und das gleiche Tastverhältnis $W/\Lambda$ aufweisen.

Fig. 1

Fig.2

Fig. 3

8

Fig. 4

| Bezeichnung der Parameter | Werte der Parameter |
|---|---|
| Injektionsstrom | 40 mA |
| Bauelementelänge | 235,4 μm |
| W/Λ | 0,5 |
| $n_{eff}$ | 3,25 |
| Temperatur | 20 °C |
| Streuverluste | 10 $cm^{-1}$ |
| Λ | 235 μm |
| differenzielle Verstärkung dg/dn | $3 \cdot 10^{-16}$ $cm^2$ |
| differenzieller Brechungsindex dN/dn | $-1,57 \cdot 10^{-20}$ $cm^3$ |

Fig.5

10

Europäisches
Patentamt

**EUROPÄISCHER RECHERCHENBERICHT**

Nummer der Anmeldung

EP 94 11 5860

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG |
|---|---|---|---|
| A | EP-A-0 390 614 (BRITISH TELECOM) <br> * Zusammenfassung * <br> * Spalte 7, Zeile 1 - Zeile 8; Abbildungen 7,8,11 * <br> --- | 1-5 | G02F1/00 <br> H01S3/085 |
| A | PATENT ABSTRACTS OF JAPAN <br> vol. 13, no. 259 (E-773) 15. Juni 1989 <br> & JP-A-01 054 790 (MATSUSHITA ELECTRIC IND CO LTD) <br> * Zusammenfassung * <br> --- | 1-5,8 | |
| A | EP-A-0 559 192 (NTT) <br> * Zusammenfassung * <br> * Seite 3, Zeile 3 - Zeile 36; Abbildung 3A * <br> --- | 1-3 | |
| D,A | ELECTRONICS LETTERS., <br> Bd.28, Nr.15, 16. Juli 1992, STEVENAGE, HERTS, GB <br> Seiten 1395 - 1396 <br> A. TALNEAU ET AL 'High power operation of phase-shifted DFB lasers with amplitude modulated coupling coefficient' <br> * das ganze Dokument * <br> --- | 1 | |
| A | PATENT ABSTRACTS OF JAPAN <br> vol. 13, no. 534 (E-852) 29. November 1989 <br> & JP-A-01 218 088 (MATSUSHITA ELECTRIC IND CO LTD) <br> * Zusammenfassung * <br> --- | 1 | |
| A | US-A-4 847 857 (OHKURA) <br> * das ganze Dokument * <br> ----- | 1 | |

**RECHERCHIERTE SACHGEBIETE (Int.Cl.6)**

H01S

Der vorliegende Recherchenbericht wurde für alle Patentansprüche erstellt

| Recherchenort | Abschlußdatum der Recherche | Prüfer |
|---|---|---|
| DEN HAAG | 16. Januar 1995 | Claessen, L |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
....................................................................
& : Mitglied der gleichen Patentfamilie, übereinstimmendes
    Dokument

EPO FORM 1503 03.82 (P04C03)